# EUROPÄISCHE PATENTSCHRIFT

(11) **EP 3 941 831 B1**
(45) Veröffentlichungstag und Bekanntmachung des Hinweises auf die Patenterteilung: **07.02.2024**
(21) Anmeldenummer: 20731852.8
(22) Anmeldetag: 08.06.2020
(51) Int. Cl.: B64D 45/00, G09F 9/33, G09F 21/10

(54) **ANZEIGEVORRICHTUNG UND VERFAHREN ZU DEREN HERSTELLUNG**
INDICATOR APPARATUS AND METHOD FOR PRODUCING SAME
DISPOSITIF D'AFFICHAGE ET PROCÉDÉ DE PRODUCTION CORRESPONDANT

(30) Priorität: 23.08.2019 DE 102019212677
(43) Veröffentlichungstag der Anmeldung: 26.01.2022
(73) Patentinhaber: Airbus Operations GmbH, 21129 Hamburg (DE)
(72) Erfinder: LINDE, Peter, 21129 Hamburg (DE); NASIRI, Awista, 21129 Hamburg (DE)
(74) Vertreter: Isarpatent
(86) Internationale Anmeldenummer: PCT/EP2020/065833
(87) Internationale Veröffentlichungsnummer: WO 2021/037407

(56) Entgegenhaltungen:
- EP-A1- 3 026 734
- WO-A1-2018/185659
- US-A1- 2005 104 740
- US-A1- 2005 202 785
- US-A1- 2017 018 767

## Beschreibung

Die vorliegende Erfindung betrifft eine Anzeigevorrichtung zur Leitung von Insassen in einem von einem Flugzeugrumpf aufgenommenen Innenraum Anspruch 1, mit einer Trägereinrichtung die an einem Wandabschnitt des Innenraums angeordnet ist und mit wenigstens einem Anzeigemittel, welches den Insassen des Innenraums in Betrieb zumindest eine visuelle Information vermittelt, versehen, wobei das wenigstens eine Anzeigemittel elektrisch betreibbar ist, und wobei das wenigstens eine Anzeigemittel zu seinem Betrieb an eine Stromversorgung angeschlossen ist. Außerdem betrifft die Erfindung ein Verfahren zur Herstellung einer betreffenden Anzeigevorrichtung gemäß Anspruch 10 sowie ein mit einer solchen Anzeigevorrichtung ausgestattetes Luftfahrzeug gemäß Anspruch 12.

Derartige Anzeigevorrichtungen kennt man beispielsweise als Bestandteile von Notausgangsleitsystemen, die helfen, Passagiere oder Besatzungsmitglieder von Luftfahrzeugen zu Evakuierungsstationen zu gelangen, und sind insbesondere nützlich, wenn das Innere der Kabine in einem Notfall bis zu dem Punkt gefüllt, an dem Passagiere versuchen aus der Kabine zu entkommen mit Rauch gefüllt ist, wie beispielsweise in den Dokumenten US2005202785 A1 und US2005104740 A1 offenbart.

Weiter kennt man aus Kabinen von Luftfahrzeugen Kopfpaneele oder Kopfstücke an Vorhangschienen, sie werden beispielsweise in einer Flugzeugkabine zur Aufnahme einer Vorhangschiene bei gleichzeitiger Erzeugung einer sperrenden und/oder lichtdichten Trenneinrichtung zwischen der Oberkante eines in der Vorhangschiene geführten Trennvorhangs und der darüber liegenden Kabinendecke verwendet. Dabei gibt es außerdem die Möglichkeit, beleuchtete Hinweisschilder, z.B. Ausgangsschilder oder ein Besetzzeichen für Toiletten, in die Vorrichtung zu integrieren. Dabei werden solche Ausgangs- und Toilettenschilder momentan mit Lampen beleuchtet, wobei der notwendige Anschluss an die Daten und Stromversorgung in dem betreffenden Luftfahrzeug mit regulären Kabeln hergestellt wird.

Es sind auch Anzeigen in Spiegel bekannt, wie beispielsweise in Dokument WO2018185659 A1 offenbart, welche an unterschiedlichen Stellen eines Fahrzeugs ode Flugzeugs angebracht werden können.

Dies erfordert einen hohen Aufwand in der Fertigung und Installation, der sich bei der Bereitstellung kundenspezifischer Kabinen in den Luftfahrzeigen noch erhöht.

Beispielsweise sind bei einem bisherigen Informationspaneel eine dreistellige Anzahl von Teilen verbaut, die eine Montagezeit von mehreren Stunden beanspruchen.

Vor diesem Hintergrund liegt der vorliegenden Erfindung die Aufgabe zugrunde, eine Anzeigevorrichtung zur Verfügung zu stellen, die hilft, die Orientierung von Passagieren in der Kabine eines Luftfahrzeugs zu verbessern, die einfach herstellbar, zu montieren und zu warten ist, und die einer Notfallsituation des Luftfahrzeugs ausfallsicher betrieben werden kann.

Erfindungsgemäß wird diese Aufgabe gelöst durch eine Anzeigevorrichtung mit den Merkmalen des Patentanspruchs 1, durch eine Herstellungsverfahren mit den Merkmalen des Patentanspruchs 10 sowie durch ein Luftfahrzeug gemäß Patentanspruch 12.

Demgemäß ist eine Anzeigevorrichtung der eingangs genannten Art vorgesehen, bei der das wenigstens eine Anzeigemittel mit einer zumindest einteiligen Schicht versehen ist, an welcher die zu seinem Betrieb notwendigen Schaltkreise integriert vorgesehen sind, und bei der die Stromversorgung durch eine an die Schicht anschließbare oder angeschlossene Verbundstruktur-Batterie gebildet ist.

Dabei wird also mittels der Erfindung eine Anzeigevorrichtung etwa in Form eines Informationspaneels anhand wenigstens einer Verbundstrukturbatterie, insbesondere einer laminierten strukturellen Verbundbatterie, beleuchtet. Durch den Einsatz der betreffenden Batterie(n) selbst kann die angeschlossene Anzeigevorrichtung zum einen quasi autark betrieben werden, zum anderen wird durch die integrierte Ausbildung des Anzeigemittels die manuelle Installation und Montage von Kabelbäumen vermieden, was den Gesamtaufwand sowohl hinsichtlich Teilezahl als auch des Zeiteinsatzes verringert. Mit dem Begriff "Batterie" wird im Zusammenhang dieser Anmeldung in erster Linie im Sinne einer wieder aufladbaren Sekundärzelle verwendet, wo passend kann auch eine nicht wieder aufladbare Primärzelle gemeint sein.

Weitere vorteilhafte Ausführungsformen finden sich in den Unteransprüchen.

So kann, um einen herkömmlichen Kabelbaum in geeigneter Weise, die eine einfache Handhabung gestattet, zu ersetzen, in einer vorteilhaften Ausführungsform der erfindungsgemäßen Anzeigevorrichtung die zumindest einteilige Schicht als flexible Polymerfolie ausgebildet.

Zweckmäßigerweise kann bei einer Weiterbildung der erfindungsgemäßen Anzeigevorrichtung die zumindest einteilige Schicht mit gedruckten Leitern und SMD (surface mounted design)-Bauelementen, wie etwa LEDs, Widerstände, Logikchips oder dergleichen integriert sein. Insbesondere kann beiden Bauelementen auch ein Spannungsregler zur Ansteuerung verschiedener Leuchtmittel an der zumindest einen Schicht integriert sein Das äußere Erscheinungsbild sowie die Schnittstelle zum jeweiligen Flugzeug bleiben dabei unverändert, was die Austauschbarkeit erleichtert. Aufgrund der integrierten Leiterplattenpfade und LED ist die erfindungsgemäße Anzeigevorrichtung hinsichtlich der Beleuchtung mit den eingesetzten Verbundbatteriestrukturen sogar flexibler, und auch kompatibler im Sinne einer einfacheren Anpassung an verschiedene Anschlussstrukturen als herkömmliche Kabelbäume.

In einer vorteilhaften Ausführungsform der erfindungsgemäßen Anzeigevorrichtung kann die zumindest einteilige Schicht mehrteilig ausgebildet sein, so dass etwa Leiterstrukturen oder Bauelemente exakt dort vorgesehen werden können, wo sie eingesetzt werden, wobei die mehreren Teile der Schicht dann sowohl strukturell als auch elektrisch miteinander in Verbindung stehen können und verteilt an der Trägereinrichtung angeordnet sein können. Es kann aber, insbesondere hinsichtlich des Montageaufwands auch vorteilhaft sein, die Schicht einteilig auszubilden.

Bei einer hinsichtlich ihrer Handhabung zweckmäßigen Ausführung der Anzeigevorrichtung ist die zumindest einteilige Schicht mit einer Schnittstelle versehen. Über eine solche Schnittstelle, beispielsweise in Form eines Steckers ist die Anzeigevorrichtung insbesondere mit der jeweiligen mit der Stromversorgung verbindbar oder verbunden ist, auch eine Datenverbindung ist hierbei etablierbar, wobei die Schnittstelle hinsichtlich der Ausgestaltung im wesentlichen keinen Einschränkungen, bis auf gegebenenfalls einen möglichst geringen zu verwirklichenden Platzbedarf unterliegt. Hierbei kann ein Anschluss auch an herkömmliche und/oder bestehende Strukturen über die Schnittstelle hergestellt und/oder angepasst werden

Gemäß der erfindungsgemäßen Anzeigevorrichtung ist die Verbundstruktur-Batterie mit einer laminierten Verbundstruktur-ausgebildet. Die hierbei zum Einsatz kommenden Komposite (Composites) gelten als multifunktional einsetzbar durch Kopplung ihrer hohe mechanischen Leistung mit sekundärer physikalischer Funktionalität. Aufgrund der Fähigkeit, Energie zu speichern, bieten solche Materialien etwa erhebliche Gewichtseinsparungen auf Systemebene. Laminierte Verbundstrukturen sind dabei aus Schichten von orthotropen (mit richtungsabhängigen Materialeigenschaften) Materialien hergestellt. Deren Vorteile gegenüber herkömmlichen Materialien äußern sich etwa in einem geringeren Eigengewicht, hoher spezifischer Festigkeit, ausgezeichneter Dauerfestigkeit, hohen Steifigkeit/Gewichts-Verhältnissen und Flexibilität in der Konstruktion. Dabei kann jede einzelne Lamelle eines laminierten Strukturverbundes einer Batterief(zelle) eine separate Funktion als Elektrode, Stromabnehmer oder Trennschicht (Separator) übernehmen. Eine Verbundstruktur-Batterie kann beispielsweise so ausgelegt sein, dass sie Kohlenstoffasern als Anode, eine Glasfasertrennschicht, eine Kathode mit LiFePO₄, einen Elektrolyten mit polymerisierten Vinylesterderivaten von Polyethylenglykol und metallische Stromabnehmer aufweist

Dabei ist die schichtweise aufgebaute Verbundstruktur-Batterie mit einer oder einer Mehrzahl von Batteriezellen ausgebildet, die jeweils laminierte Schichten mit Anode, Trennschicht und Kathode aufweist bzw. aufweisen. Derart kann eine leicht integrierbare, modular aufgebaute Batterie zur Verfügung gestellt werden, deren elektrische Leistung mittels der Zellenanzahl steuerbar ist., und die ggf. auch verteilt anordenbar ist. Dabei können bei der erfindungsgemäß verwendeten Verbundstrukturbatterie aufgrund ihrer mechanischen Eigenschaften und leichter Einlagerung von Lithium-Ionen bevorzugt Kohlefasern als Elektroden eingesetzt werde.

Die Anode bzw. die Anoden und die Katoden bzw. die Kathoden sind als Pole der jeweiligen Batteriezelle mit Kohlefasern mit entsprechender Struktur oder mit einer Beschichtung ausgebildet. Kohlenstofffasern haben eine hohe Steifigkeit und Festigkeit, die eine mechanische Verstärkung und günstige elektrische Leitfähigkeitseigenschaften für den Elektronentransport in die und aus der Zelle bietet. Für die Anode können etwa verstärkte Kohlefasern verwendet werden, während die Kathode aus beschichteten Kohlefasern bestehen kann. Die Beschichtung kann hierbei Partikel auf Lithium-Metalloxid-Basis, z.B. LiFePO₄ enthalten. Kohlenstofffasern selbst können nicht als Teil der Kathode verwendet werden, da sie als Anode wirken und die Batterie somit kurzschließen könnten.

Um einen Kurzschluss zu vermeiden und sicherzustellen, dass die positive und negative Elektrode nicht in Kontakt mit der jeweils anderen Elektrode gelangen, ist eine Trennschicht (Separator) vonnöten. Der Separator leitet keine Elektronen, erlaubt aber den Transport von Ionen zwischen den Elektroden. In einer weiteren bevorzugten Ausführungsform der Anzeigevorrichtung kann daher die Trennschicht durch ein Glasfaserlaminat oder ein poröses Polyethylen gebildet sein.

Um nun jedoch Kohlenstofffasern in Verbundstruktur- Batterien verwenden zu können, wird ein Binder benötigt, um die Fasern zu binden und eine Verbund-Batterie zu bilden. Dieser kann durch ein Festelektrolyt (SBE), bevorzugt durch ein Polymer gebildet sein, um einen hohen Modul und starke lonentransporteigenschaften zu gewährleisten. Außerdem ist ein solche Verbundstruktur-Batterie, wie herkömmliche Lithium-Ionen-Batterien, empfindlich gegen Feuchtigkeit, weshalb sie vor Feuchtigkeitseinwirkung geschützt werden muss. Deswegen weisen bei einer bevorzugten Ausführung der erfindungsgemäßen Anzeigevorrichtung die Pole zur Faserverbindung der Kohlefasern jeweils einen Festelektrolyt auf, der bevorzugt durch ein Polymer gebildet ist.

In einer Weiterbildung der Anzeigevorrichtung sind die Stromabnehmer jeweils durch einen mit einem leitenden Material beschichteten thermoplastischen Kunststoff gebildet, da die Batterien bzw. ihre Zellen über Stromabnehmer an einen externen Stromkreis angeschlossen werden müssen. Diese sind nahe an den Elektroden angebracht und leiten die Energie von den Elektroden zu einem Verbraucher. In einer Lithium-Ionenbatterie werden die negativen Ionen an der Anode und die positiven Ionen an der Kathode angesammelt. Während der Entladung fließen die positiven Ionen durch den Elektrolyten zur Anode, und von der Anode durch die Stromabnehmer durch die externen Stromkreise zur Kathode. Beim Laden fließen die Elektronen von der Kathode durch den Stromabnehmer zurück, durch ein Ladegerät (eine Vorrichtung mit höherem Potential) durch den Stromabnehmer zur Anode. Gleichzeitig fließen die positiven Ionen durch den Elektrolyten zur Kathode, bis der geladene Zustand erreicht ist.

In einer bevorzugten Weiterbildung kann dabei der thermoplastische Kunststoff ein folienförmiges Polycarbonat sein, welches insbesondere mittels eines Druckverfahrens mit einer pastösen Silberschicht versehen ist. Dabei kann das Polycarbonat eine extrudierte Polycarbonatfolie sein, die flammhemmend ausgebildet ist und damit ggf. erforderliche Brandschutzklassifikationen erfüllt. Außerdem lässt sich das betreffende Polycarbonat in vorteilhafter Weise ohne Schwierigkeiten bedrucken etwa im Siebdruck- oder Offsetdruckverfahren. Durch den betreffenden Auftrag der abgeschiedenen Metallschicht werden die leitenden Stromabnehmer ausgebildet.

Gleichermaßen stellt demgemäß ein Verfahren zur Herstellung einer Anzeigevorrichtung zur Leitung von Insassen in einem von einem Flugzeugrumpf aufgenommenen Innenraum, bei dem eine Trägereinrichtung an einem Wandabschnitt des Innenraums befestigbar ist und das wenigstens ein Anzeigemittel umfasst, welches den Insassen des Innenraums in Betrieb zumindest eine visuelle Information vermittelt, wobei das wenigstens eine Anzeigemittel elektrisch betreibbar oder betrieben ist, und wobei das wenigstens eine Anzeigemittel zu seinem Betrieb an eine Stromversorgung anschließbar oder angeschlossen ist, wobei das wenigstens eine Anzeigemittel mit einer zumindest einteiligen Schicht versehen ist, an welcher die zu seinem Betrieb notwendigen Schaltkreise integriert vorgesehen sind, und wobei die Stromversorgung durch eine an die Schicht anschließbare oder angeschlossene Verbundstruktur-Batterie gebildet ist, eine Lösung der oben genannten Aufgabe dar, wobei das Verfahren die Schritte:
- Bereitstellen wenigstens einer Anodenschicht mit Kohlefasern, wenigstens einer Kathodenschicht mit beschichteten Kohlefasen und wenigstens einer Trennschicht mit Glasfasern oder einem porösen Polyethylen;
- Laminieren der einzelnen Schichten;
- Erhalten einer multifunktionalen Batteriezelle, die sowohl als Batterie, als auch als Lastträger einsetzbar ist.
umfasst, wobei hinsichtlich der Merkmale und deren Vorteile auf die vorangegangenen Ausführungen verwiesen werden kann.

In vorteilhaften Varianten können in dem erfindungsgemäßen Verfahren eine Mehrzahl von Batteriezellen zu einer Gesamt-Verbundstruktur-Batterie zusammengefasst und verbunden werden, Enden einer Batteriezelle oder Batterie können mit Stromabnehmern aus einem beschichteten thermoplastischen Kunststoff versehen werden, die Batteriezelle oder Batterie kann geladen und die Batteriefunktion getestet werden und/oder die ggf. geladene Batteriezelle oder Batterie kann in die Trägereinrichtung integriert oder an dieser angeordnet werden.

Schließlich stellt im Sinne der vorliegenden Erfindung auch ein mit der erfindungsgemäßen Anzeigevorrichtung versehenes Luftfahrzeug eine Lösung der eingangs gestellten Aufgabe dar.

Die vorliegende Erfindung wird nachfolgend anhand der in den schematischen Figuren angegebenen Ausführungsbeispiele näher erläutert. Es zeigen dabei in teilweise stark schematisierter Darstellung :
- Fig. 1: eine ebene Draufsicht auf ein herkömmliches (a) und ein erfindungsgemäßes (b) Informationspaneel als Anzeigevorrichtung;
- Fig. 2: eine teilweise perspektivische Draufsicht auf eine explodierte Ansicht einer erfindungsgemäßen Anzeigevorrichtung mit dem mit Schicht versehenen Anzeigemittel und der Verbundstruktur-Batterie;
- Fig.3a, b: eine perspektivische Vorderansicht einer Anzeigeeinrichtung aus der Fig.2 mit Trägereinrichtung und daran angeordnetem Anzeigemittel (Fig.3a) sowie eine rückwärtige Ansicht der gleichen Anzeigeeinrichtung mit daran sichtbar angeordneter sowie der daran als laminierter Strukturverbund ausgebildeten Batterie (Fig.3b); und

- Fig. 4: eine Darstellung der laminierten Verbundstruktur-Batterie mit Elektroden, Trennschicht und Stromabnehmern.

Die beiliegenden Figuren sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnung sind gleiche, funktionsgleiche und gleich wirkende Elemente, Merkmale und Komponenten - sofern nichts anderes ausgeführt ist - jeweils mit denselben Bezugszeichen versehen.

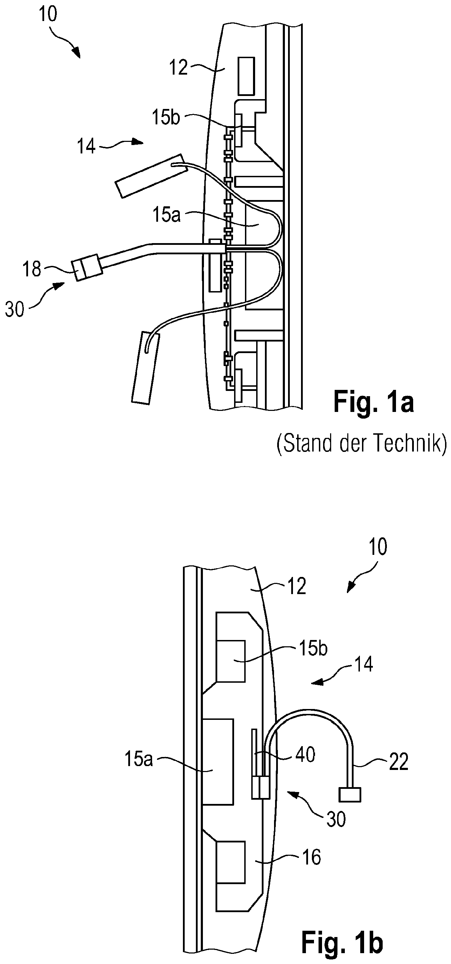

In der Fig. 1 erkennt man in der Darstellung (b) eine im Ganzen mit 10 bezeichnete, erfindungsgemäße Anzeigevorrichtung. Um dabei den Erfindungsgegenstand gegenüber herkömmlichen Anzeigevorrichtungen abzugrenzen, zeigt die Figur 1 zwei gegenüber gestellte Darstellungen zum einen einer herkömmlichen, derzeit im Einsatz befindlichen Anzeigevorrichtung (Darstellung (a)) sowie eben der erfindungsgemäßen Anzeigevorrichtung 10 (Darstellung (b)). Die Anzeigevorrichtungen 10 der Fig. 1 sind zur Leitung von Insassen in einem von einem hier nicht weiter dargestellten Flugzeugrumpf aufgenommenen Innenraum anzuordnen. Die betreffenden Anzeigevorrichtungen 10 sind jeweils mit einer Trägereinrichtung 12 versehen, die an einem ebenfalls nicht dargestellten Wandabschnitt des Innenraums angeordnet ist und weist überdies ein Anzeigemittel 14 auf, welches den Insassen des Innenraums im Betrieb zumindest eine visuelle Information vermittelt, wobei das wenigstens eine Anzeigemittel 14 elektrisch betreibbar oder betrieben ist, und wobei das wenigstens eine Anzeigemittel 14 zu seinem Betrieb an eine Stromversorgung 30 anschließbar oder angeschlossen ist. Das Anzeigemittel 14 weist hierbei mehrere Anzeigeelemente 15a, 15b auf, welche jeweils unterschiedliche Informationen an die Insassen des Innenraums übermitteln, wobei die übermittelte Information sowohl von der Art des jeweiligen Anzeigeelements 15, als auch von dessen Beleuchtungszustand abhängt.

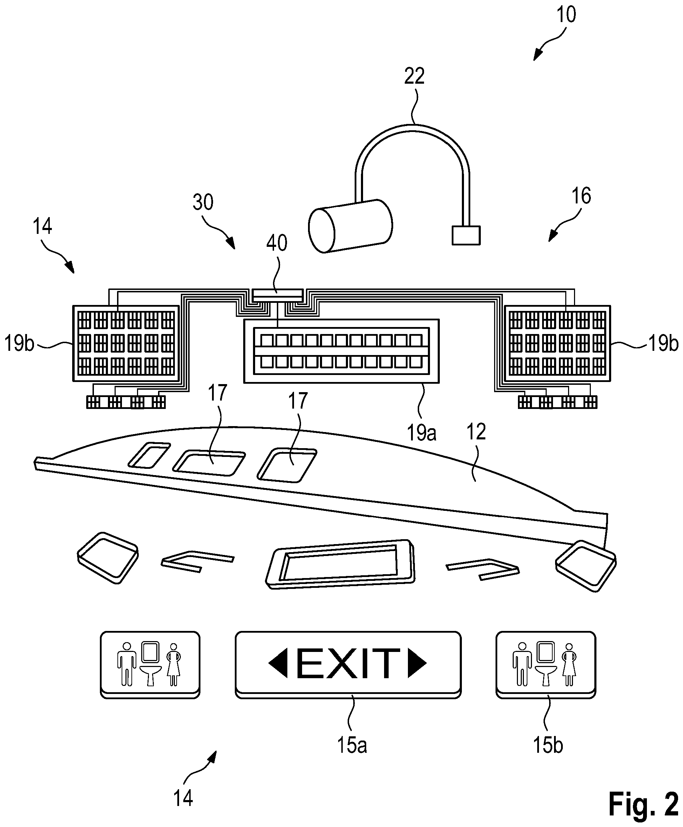

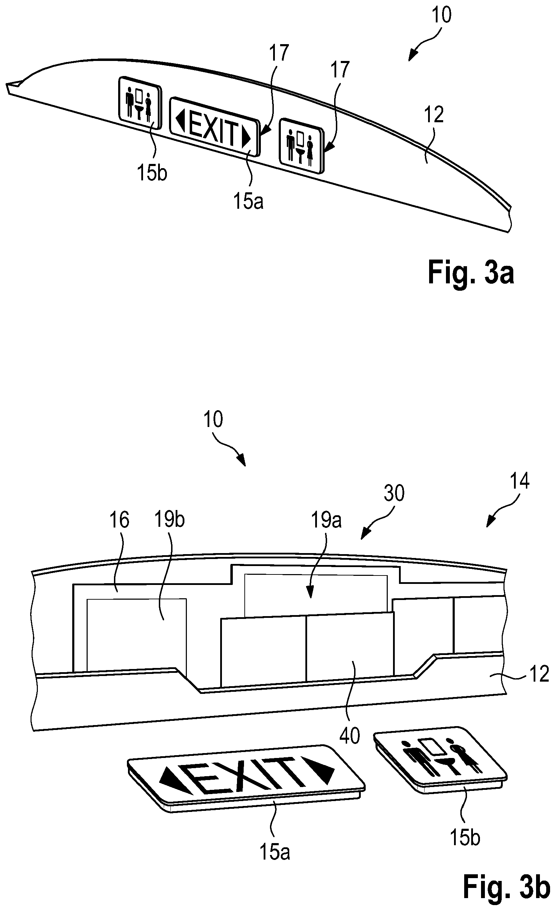

Vorliegend handelt es sich bei den Anzeigeelementen 15a, 15b zum einen um hinterleuchtbare Richtungsanzeigen für Ausgänge, zum anderen um ikonisierte Hinweisschilder auf Toiletteneinrichtungen, deren Beleuchtungszustand anzeigt, ob die betreffende Einrichtung frei oder besetzt ist. Die erwähnten Anzeigeelemente 15a, 15b sind in den Figuren 2 und 3 besser erkennbar. Die Anzeigevorrichtung 10 der Darstellung (a) der Figur 1 ist an der dem Betrachter zugewandten Rückseite ersichtlich mit einer großen Anzahl an Schaltkreisen, Anschlüssen, Klammern und Ausstattung zur Beleuchtung versehen, deren nicht geringe Anzahl in einer beachtlichen Montagezeit an der Trägereinrichtung 12 angeordnet werden müssen. Überdies ist die Stromversorgung 30 für die Anzeigevorrichtung 10 der Darstellung (a) lediglich durch einen Kabelbaumanschluss 18 angedeutet.

Demgegenüber erkennt man in der Darstellung (b) der Figur eins an der erfindungsgemäßen Anzeigevorrichtung zehn, dass zum einen das Anzeigemittel 14 mit einer zumindest einteiligen Schicht 16, die als flexible Polymerfolie ausgebildet ist, versehen ist, an welcher Schicht 16 die zum Betrieb des Anzeigemittel 14 notwendigen Schaltkreise integriert vorgesehen sind. Die einteilige Schicht 16 ist mit ihrer flexiblen Polymerfolie an der dem Betrachter ebenfalls zugewandten Rückseite der Trägereinrichtung 12 aufgebracht.

Dabei ist weiter die Stromversorgung 30 durch eine schichtförmige, an die Schicht 16 anschließbare, mit einer laminierten Verbundstruktur ausgebildete Batterie 40 gebildet, die vorliegend an der Schicht 16 selbst ausgebildet und aufgenommen ist. Um etwa mit weiteren Einrichtungen eines Luftfahrzeugs eine Datenverbindung herstellen zu können, oder um die an der Schicht 16 angeordnete Batterie 40 dauerhaft oder in vorbestimmten Intervallen aufladen zu können, ist die Schicht 16 mit einem Anschlusskabel 22 mit seinen Verbindern an die hierfür notwendigen Bordnetze angeschlossen.

Die Fig.2 zeigt die erfindungsgemäße Anzeigevorrichtung 10 in einer explodierten Ansicht, sodass die einzelnen Elemente für den Betrachter in einfacher Weise zu identifizieren sind. Dabei erkennt man im unteren Bereich der Figur zwei Anzeigeelemente 15a, 15b des Anzeigemittels 14, die in ihrer jeweiligen Gebrauchsstellung in passenden Ausnehmungen 17 der Trägereinrichtung 12 aufgenommen sind. Zwischen der Trägereinrichtung 12 und den Anzeigeelementen 15a, 15b ist weiteres Befestigungsmaterial zur Festlegung der Anzeigeelemente 15a, 15b an der Trägereinrichtung 12 zu erkennen. Für den Betrachter der Figur 2 oberhalb der Trägereinrichtung 12, erkennt man, dass das Anzeigemittel 14 der erfindungsgemäßen Anzeigevorrichtung 10 mit der hier einteiligen Schicht 16 versehen ist, an der sowohl Leuchtmittel 19a, 19b angeordnet sind, um die entsprechenden Anzeigeelemente 15 a, 15 b bei Bedarf entsprechend zu hinterleuchten, als auch die Stromversorgung 30 mit der schichtförmigen Batterie 40 in Art einer laminierten Verbundstruktur-Batterie vorgesehen ist.

Hierbei ist die Batterie 40 bei Anordnung der Schicht 16 an der Trägereinrichtung 12 erkennbar in einem Bereich vorgesehen, der sich zwischen den beiden Leuchtmittel 19b oberhalb des etwas flacheren Leuchtmittels 19a exzentrisch in Richtung des für den Betrachter linken Leuchtmittels 19b verlagert befindet. Für eine geeignete Versorgung mit Energie ist dabei die Stromversorgung 30 an einem Ort angeordnet, an welchem die elektrischen Verbindungen derjeweiligen Leuchtmittel 19a, 19b zusammentreffen. Die erwähnten Leuchtmittel 19a, 19b sind dabei erkennbar mit Leuchtdioden ausgebildet.

Überdies zeigt die Figur 2 auch noch ein Anschlusskabel 22, mittels dessen die Schicht 16 an nicht weiter dargestellte Bordnetze eines Luftfahrzeugs anschließbar ist, um eine elektrische und/oder eine Datenverbindung herzustellen.

In der Fig.3 mit ihren beiden Darstellungen der Figuren 3a und 3b erkennt man zum einen die Trägereinrichtung 12 der erfindungsgemäßen Anzeigevorrichtung 10 in einer perspektivischen Darstellung (Figur 3a), in welcher die jeweiligen Anzeigeelemente 15a, 15b in die zugehörigen Ausnehmungen 17 der Trägereinrichtung 12 eingesetzt sind, und sich mithin in dieser Darstellung in ihrer Gebrauchsstellung befinden. Demgegenüber zeigt die Figur 3b die Trägereinrichtung 12 der Anzeigevorrichtung 12 in einer rückwärtigen Ansicht, welche die Sicht auf die Schicht 16 des Anzeigemittels 14 freigibt. Hierbei erkennt man etwa ein zu einem Anzeigeelement 15b gehöriges Leuchtmittel 19b, welches als Teil der Schicht 16 ausgebildet ist. Überdies erkennt man dem Betrachter in dieser Ansicht zugewandt die an der Schicht 16 ausgebildete Batterie 40 mit laminierter Verbundstruktur, die, wie bereits in Figur 2 zu sehen war, im Bereich des zu dem Anzeigeelement 15a gehörigen Leuchtmittels 19a angeordnet ist.

Erkennbar ist hierbei weiter auch, dass die der erfindungsgemäßen Anzeigevorrichtung 10 zugeordnete Verbundstruktur-Batterie 40 einen nur geringen Platzbedarf bei nicht unbeträchtlicher Energiespeicherung hat, da die dargestellten Anzeigeelemente bei Hinterleuchtung einen Versorgungsbedarf in der Größenordnung von einigen 10 V haben. Die Verbundstruktur-Batterie 40 ist dabei in der Lage, bereits bei einer Tiefenerstreckung von nur wenigen Mikrometern eine Spannung von einigen Volt zur Verfügung zu stellen wodurch der betreffende Raumbedarf begrenzt werden kann. Eine Stromversorgung 30 kann dabei eine Mehrzahl von Verbundstruktur-Batterien 40 zusammenschalten und ansteuern, da sie mit einer nicht weiter dargestellten Spannungsregler 34 versehen ist, der wiederum als Bauelement an der Schicht 16 integriert ist.

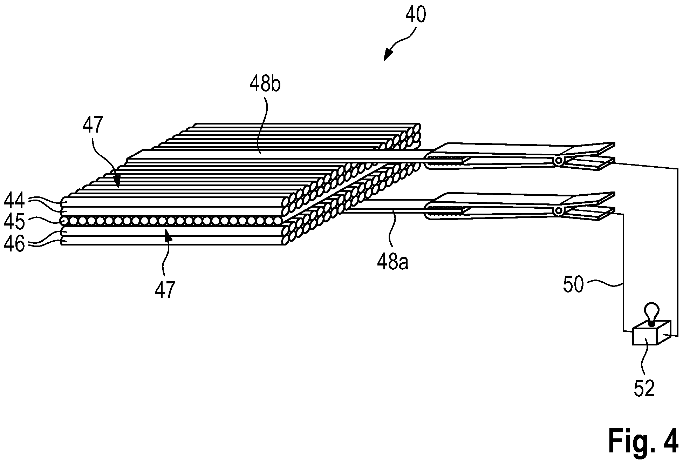

Die in der Figur 4 gezeigte Batteriezelle 42 einer Verbundstruktur-Batterie 40 dient der Veranschaulichung des schichtweisen Aufbaus einer als Stromversorgung 30 betriebenen Batterie 40 bzw. von deren Batteriezellen 42. Deren laminierte Verbundstrukturen sind aus Schichten aus orthotropen Materialien hergestellt, wobei jede Schicht (Lamelle) der laminierten Batteriezelle 42 eine separate Funktion als Elektrode, Stromabnehmer oder Trennschicht (Separator) hat. Die für den Betrachter obere Schicht besteht aus verstärkten Kohlefasern, die in einen Elektrolyt 47 (SBE, solid battery elektrolyt) eingebettet sind und bildet die negative Elektrode (Kathode 44). Die untere Schicht enthält beschichtete Kohlefasern, die in den Elektrolyten 47 eingebettet sind und bildet die positive Elektrode, die Anode 46. Zwischen der Anode 46 und Kathode 44 gibt es eine aus Glasfaser ausgebildete Trennschicht 45 als sogenannten Separator.

Darüber hinaus müssen solche Batteriezellen 42 bzw. die Batterie 40 über die Stromabnehmer 48a, 48b an einen externen Stromkreis angeschlossen werden. Diese sind eng mit den Elektroden 44, 46 verknüpft und an diesen befestigt und leiten die Energie von den Elektroden zu einem Verbraucher 52. In einer Lithium lonenbatterie werden die negativen Ionen an der Anode und die positiven Ionen an der Kathode angesammelt. Während der Entladung fließen die positiven Ionen durch den Elektrolyten 47 zur Anode 46, und die Elektronen fließen von der Anode 46 durch die Stromabnehmer 48a, 48b durch den externen Stromkreis 50 zur Kathode 44. Beim Laden fließen die Elektronen von der Kathode 44 durch den Stromabnehmer 48b zurück, durch ein nicht dargestelltes Ladegerät (eine Vorrichtung mit höherem Potential) durch den Stromabnehmer 48a zur Anode 46. Positiven Ionen strömen gleichzeitig durch den Elektrolyten 47 zur Kathode 44, bis der geladene Zustand erreicht ist.

Demgemäß betrifft die Erfindung also insbesondere eine Anzeigevorrichtung 10 zur Leitung von Insassen in einem von einem Flugzeugrumpf aufgenommenen Innenraum, mit einer Trägereinrichtung 12 die an einem Wandabschnitt des Innenraums angeordnet ist und mit wenigstens einem Anzeigemitte 14, welches den Insassen des Innenraums in Betrieb zumindest eine visuelle Information vermittelt, versehen ist, wobei das wenigstens eine Anzeigemittel 14 elektrisch betreibbar oder betrieben ist, und wobei das wenigstens eine Anzeigemittel 14 zu seinem Betrieb an eine Stromversorgung 30 anschließbar oder angeschlossen ist. Erfindungsgemäß ist vorgesehen, dass das wenigstens eine Anzeigemittel 14 mit einer zumindest einteiligen Schicht 16 versehen ist, an welcher die zu seinem Betrieb notwendigen Schaltkreise integriert vorgesehen sind, und dass die Stromversorgung 30 durch wenigstens eine an die Schicht 16 anschließbare oder angeschlossene, schichtweise aufgebaute Verbundstruktur-Batterie 40 gebildet ist.

Mittels der erfindungsgemäßen Anzeigevorrichtung 10 kann etwa ein Notausgangssystem geschaffen werden, das durch die Batterie(n) 32 auch bei Beschädigung oder Ausfalls der Stromversorgung durch den Generator funktioniert. Ein solches System ist hochflexibel du ermöglicht etwa bei speziellen Kundenwünschen auch noch Anpassungen in letzter Minute. Außerdem ermöglicht die bei Luftfahrzeugen gegebene Standardisierung eine automatisierte Installation.

Dabei sind überdies Gewicht, Kosten und Durchlaufzeiten reduziert, es besteht eine gute Kompatibilität mit Leiterplattenpfaden und LEDs herkömmlicher Strukturen, außerdem wird auch noch eine Gewichts- und Volumenreduzierung erreicht.

Obwohl die vorliegende Erfindung anhand bevorzugter Ausführungsbeispiele vorstehend beschrieben wurde, ist sie darauf nicht beschränkt, sondern auf vielfältige Art und Weise modifizierbar. Insbesondere lässt sich die Erfindung in mannigfaltiger Weise verändern oder modifizieren, ohne von der Erfindung gemäß den beigefügten Ansprüchen abzuweichen.

### Bezugszeichenliste

- 10: Anzeigevorrichtung
- 12: Trägereinrichtung
- 14: Anzeigemittel
- 15a, 15b: Anzeigeelement die an der Schicht ausgebildete
- 16: Schicht
- 18: Kabelbaumanschluss
- 19a, 19b: Leuchtmittel
- 22: Anschlusskabel
- 30: Stromversorgung
- 34: Spannungsregler
- 40: Batterie
- 42: Batteriezelle
- 44: Kathode, Pol
- 45: Trennschicht (Separator)
- 46: Anode, Pol
- 47: Elektrolyt
- 48a, 48b: Stromabnehmer
- 50: externer Stromkreis
- 52: Verbraucher

## Patentansprüche

1. Anzeigevorrichtung (10) zur Leitung von Insassen in einem von einem Flugzeugrumpf aufgenommenen Innenraum, mit einer Stromversorgung (30) und einer Trägereinrichtung (12) die an einem Wandabschnitt des Innenraums befestigbar ist und mit wenigstens einem Anzeigemittel (14), welches den Insassen des Innenraums in Betrieb zumindest eine visuelle Information vermittelt, versehen ist, wobei das wenigstens eine Anzeigemittel (14) elektrisch betreibbar ist, und wobei das wenigstens eine Anzeigemittel (14) zu seinem Betrieb an die Stromversorgung (30) angeschlossen ist, wobei das wenigstens eine Anzeigemittel (14) mit einer zumindest einteiligen Schicht (16) versehen ist, an welcher die zu seinem Betrieb notwendigen Schaltkreise integriert vorgesehen sind, und dass die Stromversorgung (30) durch wenigstens eine an die Schicht (16) angeschlossene, schichtweise aufgebaute Verbundstruktur-Batterie (40) gebildet ist, wobei die schichtweise aufgebaute Verbundstruktur-Batterie (40) mit einer laminierten Verbundstruktur ausgebildet ist, wobei die schichtweise aufgebaute Batterie (40) mit einer oder einer Mehrzahl von Batteriezellen (42) ausgebildet ist, die jeweils laminierte Schichten mit Anode (46), Trennschicht (45) und Kathode (44) aufweist bzw. aufweisen, und wobei die Anode (46) bzw. die Anoden (46) und die Katode (44) bzw. die Kathoden (46) als Pole (44, 46) der jeweiligen Batteriezelle (42) jeweils mit Kohlefasern mit entsprechender Struktur oder einer Beschichtung ausgebildet sind.

2. Anzeigevorrichtung nach Anspruch 1, wobei die zumindest einteilige Schicht (16) als flexible Polymerfolie ausgebildet ist.

3. Anzeigevorrichtung nach Anspruch 1 oder 2, wobei an der zumindest einteiligen Schicht (16) gedruckte Leiter, SMD-Bauelemente und/oder weitere Bauelemente integriert sind.

4. Anzeigevorrichtung nach einem der vorhergehenden Ansprüche, wobei die zumindest einteilige Schicht (16) mehrteilig ausgebildet ist und die mehreren Teile miteinander in Verbindung stehend verteilt an der Trägereinrichtung (12) angeordnet sind oder die Schicht (16) einteilig ausgebildet ist.

5. Anzeigevorrichtung nach einem der vorhergehenden Ansprüche, wobei die zumindest einteilige Schicht (16) mit einer Schnittstelle versehen ist, über welche sie mit der Stromversorgung (30) verbindbar oder verbunden ist.

6. Anzeigevorrichtung nach einem der vorhergehenden Ansprüche, wobei die Trennschicht (45) durch ein Glasfaserlaminat oder ein poröses Polyethylen gebildet ist.

7. Anzeigevorrichtung nach einem der vorhergehenden Ansprüche, wobei die Pole (44, 46) zur Faserverbindung der Kohlefasern jeweils einen Festelektrolyt (47) aufweisen, der bevorzugt durch ein Polymer gebildet ist.

8. Anzeigevorrichtung nach einem der vorhergehenden Ansprüche, wobei die Stromabnehmer (48a, 48b) jeweils durch einen mit einem leitenden Material beschichteten thermoplastischen Kunststoff gebildet sind.

9. Anzeigevorrichtung nach Anspruch 8, wobei der Kunststoff ein folienförmiges Polycarbonat ist, welches insbesondere mittels eines Druckverfahrens mit einer pastösen Silberschicht versehen ist.

10. Verfahren zur Herstellung einer Anzeigevorrichtung (10) zur Leitung von Insassen in einem von einem Flugzeugrumpf aufgenommenen Innenraum, insbesondere einer Anzeigevorrichtung (10) nach einem der Ansprüche 2-9, mit einer Stromversorgung (30) und einer Trägereinrichtung (12) die an einem Wandabschnitt des Innenraums befestigbar ist und mit wenigstens einem Anzeigemittel (14), welches den Insassen des Innenraums in Betrieb zumindest eine visuelle Information vermittelt, wobei das wenigstens eine Anzeigemittel (14) elektrisch betreibbar ist, und wobei das wenigstens eine Anzeigemittel (14) zu seinem Betrieb an die Stromversorgung (30) angeschlossen ist, wobei das wenigstens eine Anzeigemittel (14) mit einer zumindest einteiligen Schicht (16) versehen ist, an welcher die zu seinem Betrieb notwendigen Schaltkreise integriert vorgesehen sind, und wobei die Stromversorgung (30) durch eine schichtförmige, an die Schicht (16) angeschlossene Batterie (40) gebildet ist, wobei die schichtweise aufgebaute Verbundstruktur-Batterie (40) mit einer laminierten Verbundstruktur ausgebildet ist, wobei die schichtweise aufgebaute Batterie (40) mit einer oder einer Mehrzahl von Batteriezellen (42) ausgebildet ist, die jeweils laminierte Schichten mit Anode (46), Trennschicht (45) und Kathode (44) aufweist bzw. aufweisen, und wobei die Anode (46) bzw. die Anoden (46) und die Katode (44) bzw. die Kathoden (46) als Pole (44, 46) der jeweiligen Batteriezelle (42) jeweils mit Kohlefasern mit entsprechender Struktur oder einer Beschichtung ausgebildet sind, mit den Schritten:
a. Bereitstellen wenigstens einer Anodenschicht (46) mit Kohlefasern , wenigstens einer Kathodenschicht (44) mit beschichteten Kohlefasen und wenigstens einer Trennschicht (45) mit Glasfasern oder einem porösen Polyethylen;
b. Laminieren der einzelnen Schichten (44, 45, 46);
c. Erhalten wenigstens einer multifunktionalen Batteriezelle (42), die sowohl als Batterie (40), als auch als Lastträger einsetzbar ist.

11. Verfahren nach Anspruch 10, weiter umfassend wenigstens einen der Schritte
- Zusammenfassen und Verbinden einer Mehrzahl von Batteriezellen (42) zu einer Batterie (40);
- Versehen von Enden einer Batteriezelle (42) oder Batterie (40) mit Stromabnehmern (48a, 48b) aus einem beschichteten thermoplastischen Kunststoff;
- Laden der Batteriezelle (42) oder Batterie (40) und Testen der Batteriefunktion;
- Integration der ggf. geladenen Batteriezelle (42) oder Batterie (40) in die Trägereinrichtung (12) oder Anordnung an der Trägereinrichtung (12).

12. Luftfahrzeug, welches mit einer Anzeigevorrichtung (10) nach einem der Ansprüche 1 bis 9, versehen ist, die insbesondere nach einem der Ansprüche 10 oder 11 hergestellt wurde.

## Claims

1. Display device (10) for guiding occupants within an interior accommodated by an aircraft fuselage, having a power supply (30) and a carrier unit (12) that can be secured to a wall section of the interior and provided with at least one display means (14) that imparts at least one piece of visual information to the occupants of the interior when in operation, wherein the at least one display means (14) is electrically operable, and wherein the at least one display means (14) is connected to the power supply (30) for operation thereof, wherein the at least one display means (14) has been provided with an at least one-part layer (16) on which the circuits needed for operation thereof are provided in integrated form, and that the power supply (30) is formed by at least one composite structure battery (40) of layered structure which is connected to the layer (16), wherein the composite structure battery (40) of layered structure has been formed with a laminated composite structure, wherein the battery (40) of layered structure is formed with one battery cell or a multitude of battery cells (42), each of which has laminated layers with anode (46), separation layer (45) and cathode (44), and wherein the anode (46) or anodes (46) and the cathode (44) or cathodes (46) take the form of poles (44, 46) of the respective battery cell (42), each with carbon fibres having appropriate structure or a coating.

2. Display device according to Claim 1, wherein the at least one-part layer (16) takes the form of a flexible polymer film.

3. Display device according to Claim 1 or 2, wherein printed conductors, SMD components and/or further components are integrated into the at least one-part layer (16).

4. Display device according to any of the preceding claims, wherein the at least one-part layer (16) is in multipart form and the multiple parts are connected to one another and distributed over the carrier unit (12), or the layer (16) is in one-part form.

5. Display device according to any of the preceding claims, wherein the at least one-part layer (16) has been provided with an interface via which it is connectable or connected to the power supply (30).

6. Display device according to any of the preceding claims, wherein the separation layer (45) is formed by a glass fibre laminate or a porous polyethylene.

7. Display device according to any of the preceding claims, wherein the poles (44, 46) each have a solid-state electrolyte (47), preferably formed by a polymer, for fibre connection of the carbon fibres.

8. Display device according to any of the preceding claims, wherein the current collectors (48a, 48b) are each formed by a thermoplastic coated with a conductive material.

9. Display device according to Claim 8, wherein the plastic is a polycarbonate in film form, especially provided with a silver layer in paste form by means of a printing method.

10. Method of producing a display device (10) for guiding occupants within an interior accommodated by an aircraft fuselage, especially a display device (10) according to any of Claims 2-9, having a power supply (30) and a carrier unit (12) that can be secured to a wall section of the interior and having at least one display means (14) that imparts at least one piece of visual information to the occupants of the interior when in operation, wherein the at least one display means (14) is electrically operable, and wherein the at least one display means (14) is connected to the power supply (30) for operation thereof, wherein the at least one display means (14) has been provided with an at least one-part layer (16) on which the circuits needed for operation thereof are provided in integrated form, and wherein the power supply (30) is formed by a battery (40) in layered form which is connected to the layer (16), wherein the composite structure battery (40) in layered form has been formed with a laminated composite structure, wherein the battery (40) of layered structure is formed with one battery cell or a multitude of battery cells (42), each of which has laminated layers with anode (46), separation layer (45) and cathode (44), and wherein the anode (46) or anodes (46) and the cathode (44) or cathodes (46) take the form of poles (44, 46) of the respective battery cell (42), each with carbon fibres having appropriate structure or a coating, comprising the steps of:
a. providing at least one anode layer (46) having carbon fibres, at least one cathode layer (44) having coated carbon fibres and at least one separation layer (45) comprising glass fibres or a porous polyethylene;
b. laminating the individual layers (44, 45, 46);
c. obtaining at least one multifunctional battery cell (42) usable either as battery (40) or as load carrier.

11. Method according to Claim 10, further comprising at least one of the steps of
- combining and connecting a multitude of battery cells (42) to form a battery (40);
- providing ends of a battery cell (42) or battery (40) with current collectors (48a, 48b) composed of a coated thermoplastic;
- loading the battery cell (42) or battery (40) and testing the battery function;
- integrating the optionally charged battery cell (42) or battery (40) into the carrier unit (12) or disposing it on the carrier unit (12).

12. Aircraft provided with a display device (10) according to any of Claims 1 to 9, especially produced according to either of Claims 10 and 11.

## Revendications

1. Dispositif d'affichage (10) pour guider des occupants dans un espace intérieur logé dans un fuselage d'aéronef, avec une alimentation électrique (30) et un appareil de support (12) qui peut être fixé à une section de paroi de l'espace intérieur et qui est muni d'au moins un moyen d'affichage (14) qui, en fonctionnement, transmet au moins une information visuelle aux occupants de l'espace intérieur, l'au moins un moyen d'affichage (14) pouvant fonctionner électriquement, et l'au moins un moyen d'affichage (14) étant raccordé à l'alimentation électrique (30) pour son fonctionnement, l'au moins un moyen d'affichage (14) étant muni d'une couche (16) au moins en une partie, sur laquelle les circuits nécessaires à son fonctionnement sont prévus de manière intégrée, et en ce que l'alimentation électrique (30) est formée par au moins une batterie à structure composite (40) construite en couches, raccordée à la couche (16), la batterie à structure composite (40) construite en couches étant réalisée avec une structure composite stratifiée, la batterie (40) construite en couches étant réalisée avec une ou une pluralité de cellules de batterie (42) qui présentent chacune des couches stratifiées avec une anode (46), une couche de séparation (45) et une cathode (44), et l'anode (46) ou les anodes (46) et la cathode (44) ou les cathodes (46), en tant que pôles (44, 46) de la cellule de batterie respective (42), étant respectivement réalisées avec des fibres de carbone ayant une structure correspondante ou un revêtement.

2. Dispositif d'affichage selon la revendication 1, dans lequel la couche (16) au moins en une partie est réalisée sous forme de film polymère flexible.

3. Dispositif d'affichage selon la revendication 1 ou 2, dans lequel des conducteurs imprimés, des composants SMD et/ou d'autres composants sont intégrés à la couche (16) au moins en une partie.

4. Dispositif d'affichage selon l'une quelconque des revendications précédentes, dans lequel la couche (16) au moins en une partie est réalisée en plusieurs parties et les plusieurs parties sont réparties sur l'appareil de support (12) en étant reliées entre elles, ou la couche (16) est réalisée en une partie.

5. Dispositif d'affichage selon l'une quelconque des revendications précédentes, dans lequel la couche (16) au moins en une partie est munie d'une interface par le biais de laquelle elle peut être reliée ou est reliée à l'alimentation électrique (30).

6. Dispositif d'affichage selon l'une quelconque des revendications précédentes, dans lequel la couche de séparation (45) est formée par un stratifié de fibres de verre ou un polyéthylène poreux.

7. Dispositif d'affichage selon l'une quelconque des revendications précédentes, dans lequel les pôles (44, 46) pour la liaison par fibres des fibres de carbone présentent chacun un électrolyte solide (47), qui est de préférence formé par un polymère.

8. Dispositif d'affichage selon l'une quelconque des revendications précédentes, dans lequel les collecteurs de courant (48a, 48b) sont formés chacun par une matière thermoplastique revêtue d'un matériau conducteur.

9. Dispositif d'affichage selon la revendication 8, dans lequel la matière plastique est un polycarbonate en forme de film, qui est muni d'une couche d'argent pâteuse, notamment au moyen d'un procédé d'impression.

10. Procédé de fabrication d'un dispositif d'affichage (10) pour guider des occupants dans un espace intérieur logé dans un fuselage d'aéronef, notamment d'un dispositif d'affichage (10) selon l'une quelconque des revendications 2 à 9, avec une alimentation électrique (30) et un appareil de support (12) qui peut être fixé à une section de paroi de l'espace intérieur et qui est muni d'au moins un moyen d'affichage (14) qui, en fonctionnement, transmet au moins une information visuelle aux occupants de l'espace intérieur, l'au moins un moyen d'affichage (14) pouvant fonctionner électriquement, et l'au moins un moyen d'affichage (14) étant raccordé à l'alimentation électrique (30) pour son fonctionnement, l'au moins un moyen d'affichage (14) étant muni d'une couche (16) au moins en une partie, sur laquelle les circuits nécessaires à son fonctionnement sont prévus de manière intégrée, et l'alimentation électrique (30) étant formée par une batterie (40) en couches, raccordée à la couche (16), la batterie à structure composite (40) construite en couches étant réalisée avec une structure composite stratifiée, la batterie construite en couches (40) étant réalisée avec une ou une pluralité de cellules de batterie (42), qui présentent chacune des couches stratifiées avec une anode (46), une couche de séparation (45) et une cathode (44), et l'anode (46) ou les anodes (46) et la cathode (44) ou les cathodes (46), en tant que pôles (44, 46) de la cellule de batterie respective (42), étant réalisées respectivement avec des fibres de carbone ayant une structure correspondante ou un revêtement, avec les étapes suivantes :
a. la fourniture d'au moins une couche d'anode (46) avec des fibres de carbone, d'au moins une couche de cathode (44) avec des fibres de carbone revêtues et d'au moins une couche de séparation (45) avec des fibres de verre ou un polyéthylène poreux ;
b. la stratification des couches (44, 45, 46) individuelles ;
c. l'obtention d'au moins une cellule de batterie multifonctionnelle (42) pouvant être utilisée à la fois en tant que batterie (40) et en tant que support de charge.

11. Procédé selon la revendication 10, comprenant en outre au moins l'une des étapes suivantes
- le regroupement et la liaison d'une pluralité de cellules de batterie (42) en une batterie (40) ;
- le fait de munir des extrémités d'une cellule de batterie (42) ou d'une batterie (40) de collecteurs de courant (48a, 48b) en une matière thermoplastique revêtue ;
- le chargement de la cellule de batterie (42) ou de la batterie (40) et le test du fonctionnement de la batterie ;
- l'intégration de la cellule de batterie (42) ou de la batterie (40) éventuellement chargée dans l'appareil de support (12) ou l'agencement sur l'appareil de support (12) .

12. Aéronef, muni d'un dispositif d'affichage (10) selon l'une quelconque des revendications 1 à 9, qui a notamment été fabriqué selon l'une quelconque des revendications 10 ou 11.
